# EUROPÄISCHE PATENTANMELDUNG

(11) **EP 4 596 298 A1**
(43) Veröffentlichungstag der Anmeldung: **06.08.2025**
(21) Anmeldenummer: 24221832.9
(22) Anmeldetag: 19.12.2024
(51) Int. Cl.: B60L 5/42, B60L 53/16, B60L 53/30

(54) **KONTAKTSCHIENENANORDNUNG UND LADEVERFAHREN**

(30) Priorität: 05.02.2024 DE 102024103101
(71) Anmelder: Stemmann-Technik GmbH, 48465 Schüttorf (DE)
(72) Erfinder: Brinker, Martin, 49716 Meppen (DE)
(74) Vertreter: Griepenstroh, Jörg

(57) **Zusammenfassung**

Die Erfindung betrifft eine Kontaktschienenanordnung 1 einer Ladeeinrichtung zur Übertragung elektrischer Energie auf einen stromführenden Leiter eines Fahrzeugs, aufweisend einen Kontaktschienenträger 2, an dem eine Kontaktschiene 3 angeordnet ist, wobei zwischen dem Kontaktschienenträger 2 und der Kontaktschiene 3 wenigstens ein elektrisches Heizelement 14 einer Kontaktschienenheizung angeordnet ist, wobei das elektrische Heizelement 14 eine Heizfolie ist.

## Beschreibung

Die Erfindung betrifft eine Kontaktschienenanordnung mit den Merkmalen des Patentanspruches 1 und ein Ladeverfahren gemäß Patentanspruch 10.

Elektrisch angetriebene Fahrzeuge, wie z. B. Busse können stationär, d.h. im Stand geladen werden, indem an einer Ladestation eine verlagerbare Kontaktschiene einer Ladeeinrichtung insbesondere von oben an fahrzeugseitige elektrische Leiter herangeführt wird. Eine witterungsbedingte Vereisung der Ladestation und insbesondere der Kontaktschiene kann das Laden erschweren oder sogar unmöglich machen.

Der Erfindung liegt die Aufgabe zugrunde, eine Kontaktschienenanordnung einer Ladeeinrichtung aufzuzeigen, die auch bei niedrigeren Temperaturen, insbesondere bei eisbildender Witterung betriebssicher verwendet werden kann. Es soll ein geeignetes Ladeverfahren aufgezeigt werden, dass eine solche Kontaktschienenanordnung nutzt.

Die Erfindung löst diese Aufgabe durch eine Kontaktschienenanordnung mit den Merkmalen des Patentanspruches 1 bzw. 10.

Die erfindungsgemäße Kontaktschienenanordnung umfasst einen Kontaktschienenträger, an dem eine Kontaktschiene für das Herstellen eines Kontaktes mit einem fahrzeugseitigen stromführenden Leiter angeordnet ist. Die Kontaktschiene ist ein Verschleißteil. Die Kontaktschienenanordnung ist dafür ausgebildet, dass die Kontaktschiene regelmäßig ausgetauscht werden kann. Es handelt sich daher um eine lösbare Verbindung zwischen dem Kontaktschienenträger und der Kontaktschiene.

Erfindungsgemäß ist zwischen dem Kontaktschienenträger und der Kontaktschiene wenigstens ein elektrisches Heizelement einer Kontaktschienenheizung angeordnet. Das elektrische Heizelement wird über einen eigenen Heizkreislauf beheizt. Zu der Kontaktschienenheizung gehört mithin eine Stromquelle, die an das Heizelement angeschlossen ist, sowie eine entsprechende Steuerung für die Stromquelle. Das Heizelement steht in Kontakt mit der Kontaktschiene und dient dazu, die Kontaktschiene eisfrei zu halten, um sicherzustellen, dass anhaftendes Eis nicht zu einer Unterbrechung des elektrischen Kontaktes mit einem fahrzeugseitigen stromführenden Leiter führt.

Das wenigstens eine Heizelement ist als Heizfolie ausgebildet. Insbesondere ist auch nur ein einziges Heizelement und damit auch nur eine einzige Heizfolie vorgesehen. Eine Heizfolie hat den Vorteil, dass sie besonders leicht ist und das Gewicht der Kontaktschienenanordnung nur unwesentlich erhöht. Heizfolien sind sehr dünn und nur wenige Millimeter dick, und in der Regel dünner als 3 mm. Sie können selbstklebend ausgeführt sein. Sie sind biegbar und können in ihrem Verlauf leicht an gebogene Kontaktschienen angepasst werden.

Die Heizfolie ist so angeordnet, dass sie mit der Kontaktschiene in Kontakt steht, so dass die von dem Heizelement als Wärmequelle ausgehende Wärme in die Kontaktschiene unmittelbar eingeleitet wird und eine Eisbildung an der Kontaktschiene verhindert. Wichtig hierbei ist, dass ein möglichst (groß)flächiger Kontakt zwischen der Heizfolie und der Kontaktschiene besteht. Je größer die Kontaktfläche zwischen der Heizfläche und der Kontaktschiene ist desto eher können Heizfolien mit geringerer Heizleistung eingesetzt werden.

Um den engen und möglichst vollflächigen Kontakt herzustellen, kann das Heizelement bzw. die Heizfolie vorzugsweise Bereich einer Anlagefläche des Kontaktschienenträgers für die Kontaktschiene angeordnet sein. In einer ersten Ausführungsform der Erfindung ist in einer Anlagefläche des Kontaktschienenträgers eine Vertiefung ausgebildet, in welcher das wenigstens eine Heizelement angeordnet ist. Das Heizelement bzw. die Heizfolie kann geringfügig über die Anlagefläche vorstehen, so dass es bei der Montage der Kontaktschiene fest gegen die Kontaktschiene gepresst wird. Die Kontaktschiene liegt dadurch möglichst flächig an dem Heizelement bzw. der Heizfolie an. Durch die Vertiefung können auch dickere bzw. leistungsstärkere Heizelemente oder Heizfolien oder auch druckempfindlichere Heizelemente verbaut werden. Die Anlagefläche bzw. der umlaufende Randbereich außerhalb der Vertiefung dient als Kontaktfläche zwischen dem Kontaktschienenträger und der Kontaktschiene. Bei allen Ausführungsformen kann an dem Kontaktschienenträger ein Isolator zur thermischen Isolation des wenigstens eines Heizelementes angeordnet sein, so dass die Wärme auf die Kontaktschiene übertragen wird und nicht auf den Kontaktschienenträger. Es kann ein Isolator in der Vertiefung angeordnet sein. Der Kontaktschienenträger kann selbst aus einem thermisch isolierenden Material hergestellt sein.

Das Heizelement kann alternativ ohne Vertiefung im Kontaktschienenträger klemmend zwischen der Anlagefläche und der Kontaktschiene gehalten sein. In diesem Fall liegt die Kontaktschiene nicht unmittelbar auf der Anlagefläche auf, sondern auf dem Heizelement. Diese Art der Befestigung hat den Vorteil, dass das Heizelement bzw. die Folie extrem sicher und fest gehalten ist und gleichzeitig im innigen Kontakt mit der Kontaktschiene steht, so dass ein besonders guter Wärmeübergang gewährleistet ist.

Die Wirkung des Heizelementes wird maximiert, wenn der Wärmestrom über eine möglichst große Fläche in die Kontaktschiene eingeleitet werden kann. Daher sollte das Heizelement sich über mindestens 90 % der Länge der Kontaktschiene erstrecken, vorzugsweise über die gesamte Länge der Kontaktschiene. In gleicher Weise sollte sich das Heizelement über mindestens 50 % der quer zur Länge der Kontaktschiene gemessenen Breite erstrecken, insbesondere über 70 bis 80, vorzugsweise 100 % der Breite der Kontaktschiene, soweit dies technisch möglich ist.

Zur Montage der Kontaktschiene an dem Kontaktschienenträger sind Befestigungselemente erforderlich, die typischerweise von Schraubbolzen gebildet werden, welche die Kontaktschiene durchsetzen. Dementsprechend ist es bei großflächigen Heizelementen zweckmäßig, Öffnungen zur Aufnahme von Befestigungselementen vorzusehen, mit denen die Kontaktschiene an dem Kontaktschienenträger befestigt ist. Wenn die Befestigungselemente, insbesondere Schrauben, auch die Öffnungen in den Heizelementen durchsetzen, fixieren sie auch die Heizelemente, so dass diese stets unverlierbar und korrekt positioniert an der Kontaktschienenanordnung gehalten sind. Zudem sind die Heizelemente aufgrund ihrer Anordnung zwischen der Kontaktschiene und dem Kontaktschienenträger stets vor Beschädigungen und äußeren Einflüssen geschützt.

Je nach Ausgestaltung des Kontaktschienenträgers kann die Kontaktschiene mit einer Schmalseite gegenüber dem Kontaktschienenträger vorstehen. Der Kontakt mit dem stromführenden Leiter erfolgt dann über den vorstehenden Bereich der Schmalseite. Eine solche Kontaktschiene besitzt zumeist einen im wesentlichen rechteckigen Querschnitt. Der maximale Wärmeeintrag kann über die Breitseite erfolgen, die vorzugsweise der Vorderseite des Kontaktschienenträgers zugewandt ist. Zwischen der Vorderseite des Kontaktschienenträgers und der Breitseite der Kontaktschiene ist dementsprechend das wenigstens eine Heizelement, insbesondere eine Heizfolie, angeordnet. Die Heizfolie kann aufgrund dieser Anordnung auch dann nicht beschädigt werden, wenn die Verschleißgrenze der Kontaktschiene erreicht wurde.

In einer Weiterbildung der Erfindung kann die Anlagefläche, an der die Kontaktschiene anliegt, gegenüber der Vorderseite des Kontaktschienenträgers soweit zurückspringen, dass eine Tasche gebildet ist, in welcher die Kontaktschiene angeordnet ist. Auf diese Weise können leichtere und kompaktere Kontaktschienenträger zum Einsatz kommen. Die zurückspringende Anlagefläche vergrößert nochmals den Schutz des wenigstens einen Heizelements gegenüber äußeren Einflüssen, da das Heizelement selber ebenfalls in der Tasche angeordnet ist. Wenn eine Schmalseite der Kontaktschiene gegenüber dem Kontaktschienenträger vorsteht, handelt es sich vorzugsweise um eine Anordnung, bei welcher die Anlagefläche vertikal verläuft. Die Kontaktfläche der Kontaktschiene mit einem elektrischen Leiter steht senkrecht zur Anlagefläche und verläuft dementsprechend horizontal quer zur Fahrtrichtung des Fahrzeuges.

In einer alternativen Ausführungsform der Erfindung verläuft die Anlagefläche selbst horizontal, wobei sich die Kontaktschiene in Vertikalrichtung benachbart angeordnet ist. Auch für diese Ausführungsform gelten die vorstehend beschrieben Vorteile im übertragenen Sinne. Das flächige Heizelement, vorzugsweise eine Heizfolie, befindet sich in horizontaler Orientierung zwischen der Kontaktschiene und dem Kontaktschienenträger. In gleicher Weise kann auch ein solches Heizelement Öffnungen zur Aufnahme von Befestigungselementen aufweisen. Auch bei horizontalen Anlageflächen sollten die Heizelemente sich über eine möglichst große Fläche der Kontaktschiene erstrecken, d.h. über vorzugsweise mindestens 90 % der Länge und mindestens 50 %, vorzugsweise 80% der Breite, wobei das Heizelement möglichst die gleiche Fläche einnehmen sollte wie die Kontaktschiene, um die Fläche für den Wärmeübergang zu maximieren.

Das erfindungsgemäße Ladeverfahren basiert auf der Verwendung der oben beschriebenen Kontaktschienenanordnung. Die stationäre Ladeeinrichtung weist die besagte Kontaktschienenanordnung zur Übertragung elektrischer Energie auf einen stromführenden Leiter eines Fahrzeugs auf. Die Ladeinrichtung ist insbesondere eine Absenkeinheit, wie z.B. ein Pantograph, der in Richtung zu dachseitigen stromführenden Leitern eines Fahrzeugs von oben kommend abgesenkt wird und dabei die Kontaktschienenanordnung in elektrisch leitenden Kontakt mit dem Fahrzeug bringt, um dessen Energiespeicher zu laden. Bereits vor dem Laden wird sichergestellt, dass das Laden nicht durch Eisbildung behindert wird, indem das elektrische Heizelement der Kontaktschienenheizung die Kontaktschiene beheizt, bevor der Kontakt hergestellt wird. Das Beheizen kann durch einen Temperatursensor ausgelöst werden, der die Umgebungstemperatur misst. Sobald die Temperatur unter den Gefrierpunkt fällt, kann eine Steuerung veranlassen, dass die Kontaktschiene beheizt wird. Das Beheizen kann zeitgesteuert oder annährungsgesteuert, d.h. wenn sich ein Fahrzeug zum Laden nähert oder ankündigt, oder bewegungsgesteuert, z.B. wenn die Kontaktschiene verlagert wird oder auch in regelmäßigen Intervallen oder zu bestimmten Tageszeiten erfolgen. Es ist auch möglich, dass durch eine optische Erfassung der Vereisung oder ein das Gewicht berücksichtigendes Eislast-Monitoring ggf. in Verbindung mit Wetterdaten und/oder mit Hilfe von empirischen Werten oder mit Hilfe einer KI eine adaptive Anpassung der Einschaltzeitpunkte und Einschaltdauer erfolgt, so dass die Ladeeinrichtung zum gewünschten Nutzungszeitpunkt einsatzbereit ist. Das manuelle Ein- und Ausschalten der Kontaktschienenheizung ist ebenso möglich.

Die Erfindung wird nachfolgend anhand von in schematischen Zeichnungen dargestellten Ausführungsbeispielen näher erläutert. Es zeigen:
- Figur 1: eine perspektivische Darstellung einer Kontaktschienenanordnung;
- Figur 2: die Kontaktschienenanordnung der Figur 1 in einer Frontansicht;
- Figur 3: die Kontaktschienenanordnung der Figuren 1 und in einem Schnitt entlang der Linie III-III in Figur 2;
- Figuren 4 bis 6: jeweils Varianten einer Kontaktschienenanordnung in einer Ansicht entsprechend der Schnittlinie III-III in Figur 2;
- Figur 7: eine weitere Ausführungsform einer Kontaktschienenanordnung im Querschnitt.

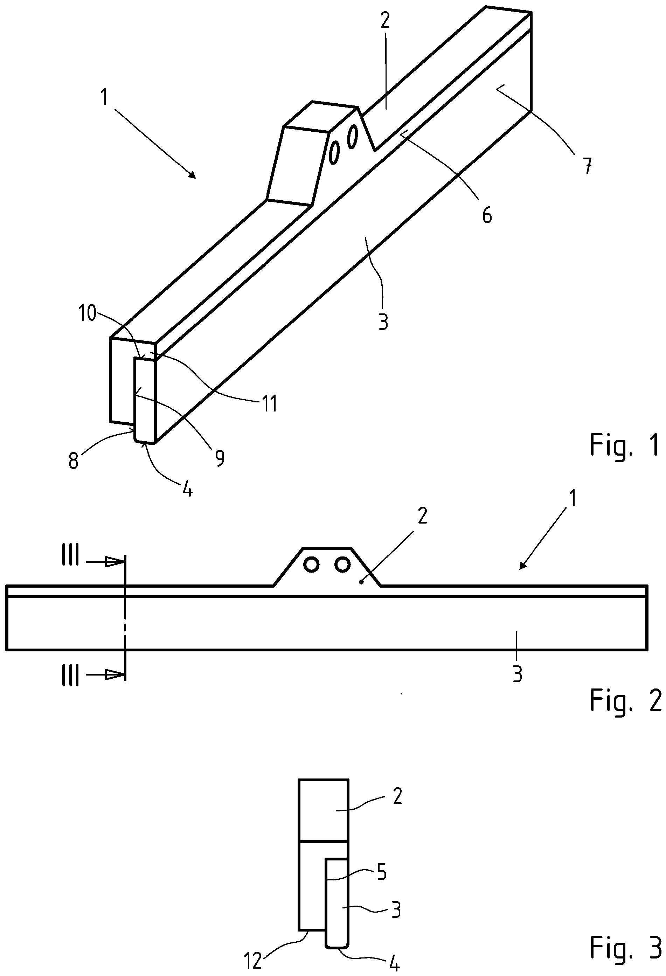

Die Figur 1 zeigt eine Kontaktschienenanordnung 1 einer nicht näher dargestellten Ladeeinrichtung zum Laden eines elektrisch angetriebenen Fahrzeugs. Die Ladeeinrichtung ist dazu ausgebildet, die Kontaktschienenanordnung 1 in elektrisch leitenden Kontakt mit Leitern am Fahrzeug zu bringen. Die Kontaktschienenanordnung 1 wird so an der Ladeeinrichtung montiert, dass der fahrzeugseitige stromführende Leiter im Wesentlichen senkrecht zur Kontaktschienenanordnung 1 verläuft.

Die Kontaktschienenanordnung 1 besitzt einen Kontaktschienenträger 2, der mit der Ladeeinrichtung verbunden ist, sowie eine für den Kontakt mit dem fahrzeugseitigen stromführenden Leiter vorgesehene Kontaktschiene 3, die mit dem Kontaktschienenträger 2 in nicht näher dargestellter Weise verbunden ist, insbesondere über mehrere Schraubelemente verschraubt ist. Die Figuren 2 und 3 zeigen die Kontaktschienenanordnung 1 in der Frontansicht und im Schnitt.

Die Kontaktschiene 3 ist im Querschnitt quaderförmig und besitzt eine in der Bildebene nach unten über den Kontaktschienenträger 2 vorstehende Schmalseite 4. Das ist die Kontaktseite, mit welcher die Kontaktschiene 3 mit dem elektrischen Leiter in Kontakt kommt. Die Kontaktschiene 3 ist genauso lang wie der Kontaktschienenträger 2. Die Kontaktschiene 3 befindet sich zudem in einer Tasche 5, so dass die Kontaktschiene 3 nicht über eine Vorderseite 6 des Kontaktschienenträgers 2 vorsteht. Die Kontaktschiene 3 schließt vorderseitig mit der Vorderseite 6 des Kontaktschienenträgers 2 ab. In einer alternativen Ausgestaltung kann die Kontaktschiene 3 über die Vorderseite 6 vorstehen. Die Kontaktschiene 3 besitzt eine Vorderseite 7, die als Breitseite ausgestaltet ist. Gegenüberliegend der Vorderseite 7 befindet sich die Rückseite 8 der Kontaktschiene 3, die an einer zurückspringenden Anlagefläche 9 innerhalb der Tasche 5 angeordnet ist. In Hochrichtung stützt sich die Kontaktschiene 3 mit ihrer oberen Schmalseite 10 an einem Steg 11 der Tasche ab. Die Tasche 5 ist gewissermaßen eine Ausklinkung oder Eckausnehmung des Kontaktschienenträgers 2, so dass die Tasche 5 zur Vorderseite 6 des Kontaktschienenträgers 2 und zu dessen in der Bildseite unten liegenden Unterseite 12 offen ist.

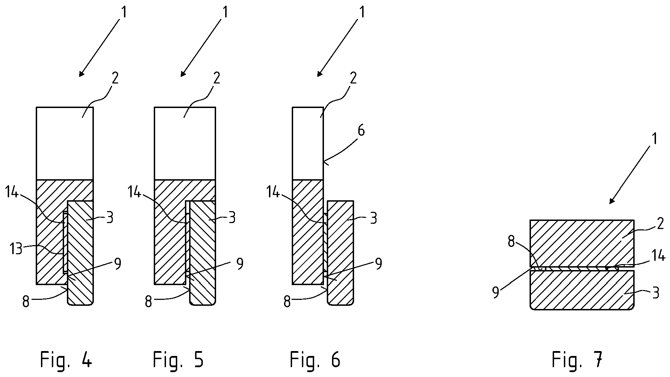

Die Figuren 4 bis 6 zeigen unterschiedliche Ausführungsformen derartiger Kontaktschienenanordnungen 1 entsprechend der Schnittebene III-III in Figur 2. In der Figur 4 befindet sich innerhalb der Anlagefläche 9 zusätzlich eine Vertiefung 13. Innerhalb der flächigen Vertiefung 13 ist ein Heizelement 14 angeordnet, das in nicht näher dargestellter Weise mit einer Kontaktschienenheizung verbunden ist. Der Begriff Kontaktschienenheizung umfasst die Mittel zur Steuerung und Energieversorgung des elektrischen Heizelementes. Das elektrische Heizelement 14 kann bei Bedarf zu- und abgeschaltet werden. Es kann je nach Bedarf mit mehr oder weniger elektrischer Energie versorgt werden, um unterschiedliche Heizleistungen je nach Witterung einzustellen.

Die Figur 4 zeigt ein Ausführungsbeispiel, bei welcher das Heizelement 14 maximal geschützt ist und keinerlei Umwelteinflüssen ausgesetzt ist.

In einer alternativen Ausgestaltung gemäß Figur 5 wurde auf die Vertiefung 13 verzichtet. Das Heizelement ist klemmend zwischen der Rückseite 8 der Kontaktschiene und der Anlagefläche 9 gehalten. In nicht näher dargestellter Weise erstreckt sich das jeweilige Heizelement 14 im Wesentlichen über die gesamte Länge der Kontaktschiene 3 bzw. die Länge des Kontaktschienenhalters 2.

Das Ausführungsbeispiel der Figur 6 weicht von demjenigen der Figuren 4 und 5 insofern ab, als dass auf die Ausgestaltung einer Tasche innerhalb des Kontaktschienenträgers 2 verzichtet wurde. Dadurch ist der Kontaktschienenträger 2 insgesamt wesentlich schmaler und dadurch auch leichter. Die Dimensionen der Kontaktschiene 3 sind identisch geblieben. Auch das Heizelement 14 ist identisch. Es befindet sich wiederum klemmend zwischen der Rückseite 8 der Kontaktschiene und der Anlagefläche 9, die in diesem Fall nicht zurückspringt, sondern mit der Vorderseite 6 des Kontaktschienenträgers 2 zusammenfällt.

Während bei den Ausführungsbeispielen der Figuren 1 bis 6 die Anlagefläche 9 stets vertikal orientiert ist, sieht eine alternative Ausgestaltung gemäß der Figur 7 vor, dass der Kontaktschienenträger 2 in der Bildebene oben horizontal angeordnet ist mit einer horizontalen Anlagefläche 8, wobei die Rückseite 9 der Kontaktschiene 3 ebenfalls horizontal angeordnet ist und parallel zur Anlagefläche 8 ausgerichtet ist. Die Kontaktschiene 3 besitzt dieselbe Breite und Länge wie der Kontaktschienenträger 2. Für funktionsgleiche Komponenten werden die bereits in den Figuren 1 bis 6 eingeführten Bezugszeichen verwendet. Zwischen der Rückseite 9 der Kontaktschiene 3 und der Anlagefläche 8 des Kontaktschienenträgers 2 befindet sich wiederum ein flächiges Heizelement 14, insbesondere in Form einer Heizfolie. Funktional entspricht diese Bauform derjenigen der Figuren 5 und 6, lediglich die Dimensionierung der Kontaktschiene 3 ist eine andere sowie die Befestigungsrichtung zwischen dem Kontaktschienenträger 2 und der Kontaktschiene 3.

### Bezugszeichen:

- 1 -: Kontaktschienenanordnung
- 2 -: Kontaktschienenträger
- 3 -: Kontaktschiene
- 4 -: Schmalseite von 3
- 5 -: Tasche in 2
- 6 -: Vorderseite von 2
- 7 -: Vorderseite von 3
- 8 -: Rückseite von 3
- 9 -: Anlagefläche von 2
- 10 -: obere Schmalseite von 3
- 11 -: Steg
- 12 -: Unterseite von 2
- 13 -: Vertiefung in 9
- 14 -: Heizelement

## Patentansprüche

1. Kontaktschienenanordnung (1) einer Ladeeinrichtung zur Übertragung elektrischer Energie auf einen stromführenden Leiter eines Fahrzeugs, aufweisend einen Kontaktschienenträger (2), an dem eine Kontaktschiene (3) angeordnet ist, wobei zwischen dem Kontaktschienenträger (2) und der Kontaktschiene (3) wenigstens ein elektrisches Heizelement (14) einer Kontaktschienenheizung angeordnet ist, **dadurch gekennzeichnet, dass** das wenigstens eine Heizelement (14) als Heizfolie ausgebildet ist, die mit der Kontaktschiene (3) in Kontakt steht.

2. Kontaktschienenanordnung (1) nach Anspruch 1, **dadurch gekennzeichnet, dass** der Kontaktschienenträger (2) eine Anlagefläche (9) für die Kontaktschiene (3) aufweist, wobei in der Anlagefläche (9) eine Vertiefung (13) ausgebildet ist, in welcher das wenigstens eine Heizelement (14) angeordnet ist.

3. Kontaktschienenanordnung (1) nach Anspruch 1 oder 2, **dadurch gekennzeichnet, dass** der Kontaktschienenträger (2) eine Anlagefläche (9) für die Kontaktschiene (3) aufweist, wobei das wenigstens eine Heizelement (14) zwischen der der Anlagefläche (9) und der Kontaktschiene (3) klemmend gehalten ist.

4. Kontaktschienenanordnung (1) nach einem der Ansprüche 1 bis 3, **dadurch gekennzeichnet, dass** das wenigstens eine Heizelement (14) sich über mindestens 90% der Länge der Kontaktschiene (3) erstreckt.

5. Kontaktschienenanordnung (1) nach einem der Ansprüche 1 bis 4, **dadurch gekennzeichnet, dass** sich das wenigstens eine Heizelement (14) über mindestens 50 % der quer zur Länge der Kontaktschiene (3) gemessenen Breite erstreckt.

6. Kontaktschienenanordnung (1) nach einem der Ansprüche 1 bis 5, **dadurch gekennzeichnet, dass** das wenigstens eine Heizelement (14) Öffnungen aufweist zur Aufnahme von Befestigungselementen, mit denen die Kontaktschiene (3) an dem Kontaktschienenträger (2) befestigt ist.

7. Kontaktschienenanordnung (1) nach einem der Ansprüche 1 bis 6, **dadurch gekennzeichnet, dass** die Anlagefläche (9) gegenüber einer Vorderseite (6) des Kontaktschienenträgers (2) so weit zurückspringt, dass eine Tasche (5) gebildet ist, in welcher die Kontaktschiene (3) angeordnet ist.

8. Kontaktschienenanordnung (1) nach einem der Ansprüche 1 bis 7, **dadurch gekennzeichnet, dass** die Anlagefläche (9) vertikal verläuft.

9. Kontaktschienenanordnung (1) nach einem der Ansprüche 1 bis 8, **dadurch gekennzeichnet, dass** die Anlagefläche (9) horizontal verläuft, wobei die Kontaktschiene (3) in Vertikalrichtung benachbart zum Kontaktschienenträger (2) befindet.

10. Ladeverfahren unter Verwendung einer Kontaktschienenanordnung (1) nach einem der Ansprüche 1 bis 9 an einer Ladeeinrichtung zur Übertragung elektrischer Energie auf einen stromführenden Leiter eines Fahrzeugs, wobei das elektrische Heizelement (14) der Kontaktschienenheizung die Kontaktschiene (3) beheizt, bevor die Kontaktschiene (3) von der Ladeeinrichtung von oben kommend mit einem dachseitig angeordneten stromführenden Leiter in Kontakt gebracht wird.
